(19) Europäisches Patentamt
European Patent Office
Office européen des brevets

(11) **EP 4 585 976 A1**

(12) **EUROPEAN PATENT APPLICATION**
published in accordance with Art. 153(4) EPC

(43) Date of publication:
   **16.07.2025 Bulletin 2025/29**

(21) Application number: **23871417.4**

(22) Date of filing: **25.07.2023**

(51) International Patent Classification (IPC):
   *G01V 3/08* (2006.01)    *H01H 36/00* (2006.01)

(52) Cooperative Patent Classification (CPC):
   **G01V 3/08; H01H 36/00**

(86) International application number:
   **PCT/JP2023/027214**

(87) International publication number:
   **WO 2024/070174 (04.04.2024 Gazette 2024/14)**

(84) Designated Contracting States:
   **AL AT BE BG CH CY CZ DE DK EE ES FI FR GB
   GR HR HU IE IS IT LI LT LU LV MC ME MK MT NL
   NO PL PT RO RS SE SI SK SM TR**
   Designated Extension States:
   **BA**
   Designated Validation States:
   **KH MA MD TN**

(30) Priority: **27.09.2022 JP 2022154178**

(71) Applicant: **Atryz Yodogawa Co., Ltd.
   Osaka-shi, Osaka 530-0001 (JP)**

(72) Inventor: **OTAGAKI, Takayasu
   Osaka-shi, Osaka 530-0001 (JP)**

(74) Representative: **Morbidini, Marco et al
   Kilburn & Strode LLP
   Lacon London
   84 Theobalds Road
   London WC1X 8NL (GB)**

(54) **ELECTROSTATIC CAPACITANCE SENSOR**

(57)    An object is to provide an electrostatic capacitance sensor that can expand the detection range without enlarging the sensor electrode and does not need to be adjusted for each type of equipment according to the lineup of equipment in which the electrostatic capacitance sensor is installed. An electrostatic capacitance sensor (1) comprises a sensor electrode (2), a detection device (4) for detecting the user's touch operation to a detection region (8) based on a change in the capacitance of the sensor electrode (2), and a conductor (3) provided in the detection region (8) where a touch operation is detected. The conductor (3) is disposed opposite to the sensor electrode (2) with a gap therebetween or with a dielectric interposed therebetween, the area of the conductor (3), as viewed from a direction in which the sensor electrode (2) and the conductor (3) face each other, is larger than the area of the sensor electrode (2), and a part of the conductor (3) faces the sensor electrode (2).

Fig.2

EP 4 585 976 A1

**Description**

Technical Field

The present disclosure relates to an electrostatic capacitance sensor that detects the contact or approach action of a detectable object with respect to a detection region based on changes in the capacitance of a sensor electrode.

Background Art

For example, information and communication equipment, home appliances, in-vehicle products, and other types of electronic equipment are configured to execute various functions in response to the user's touch operation, and an electrostatic capacitance sensor is used to detect the user's touch operation. The electrostatic capacitance sensor has a sensor electrode arranged near a detection region where the user performs a touch operation in each type of equipment. When a part of the user's body **(e.g.,** a finger) interferes with the electric field generated by the sensor electrode, the capacitance of the sensor electrode changes from $C_0$ to $C_0+\Delta C$. By detecting this change in capacitance $\Delta C$ with a detection device connected to the sensor electrode, it is possible to determine the presence or absence of the user's touch operation on the detection region (see, for example, PTL 1). In the present disclosure, the touch operation refers to an operation in which a part of the user's body or an input tool such as a touch pen (hereinafter referred to as the "detectable object") comes into contact with or approaches the detection region.

The magnitude of the capacitance $C_0$ of the sensor electrode is proportional to the area of the sensor electrode and inversely proportional to the distance between the sensor electrode and the detectable object. Therefore, the larger the area of the sensor electrode, the larger the capacitance $C_0$ becomes; thus, the touch operation can be detected with high sensitivity even if the detection distance is increased. Moreover, a larger area of the sensor electrode makes it possible to expand the detection range that can be sensitive to the user's touch operation. Furthermore, a larger area of the sensor electrode is more effective to detect the approach action.

Citation List

Patent Literature

PTL 1: JP2015-210811A

Summary of Invention

Technical Problem

As described above, since the detection range and sensitivity of the electrostatic capacitance sensor depend on the area of the sensor electrode, if the area of the sensor electrode is changed depending on the lineup of equipment in which the electrostatic capacitance sensor is installed, the capacitance of the sensor electrode also changes, making it necessary to adjust the capacitance of the sensor electrode for each type of equipment, as well as the parasitic capacitance that depends on the sensor electrode, individual variations, sensitivity, threshold value, etc., which becomes complicated. If the area of the sensor electrode is increased, the cost increases accordingly.

The present disclosure focuses on solving the above problems, and an object thereof is to provide an electrostatic capacitance sensor that can expand the detection range without enlarging the sensor electrode and does not need to be adjusted for each type of equipment according to the lineup of equipment in which the electrostatic capacitance sensor is installed.

Solution to Problem

In order to achieve the above object, the main subject of the electrostatic capacitance sensor of the present disclosure is an electrostatic capacitance sensor according to Item 1 below.

Item **1.** An electrostatic capacitance sensor comprising a sensor electrode, and a detection device for detecting a contact or approach action of a detectable object with respect to a detection region based on a change in the capacitance of the sensor electrode,

the electrostatic capacitance sensor comprising a conductor provided in the detection region,
the conductor being disposed opposite to the sensor electrode with a gap therebetween or with a dielectric interposed therebetween, and

the area of the conductor, as viewed from a direction in which the sensor electrode and the conductor face each other, being larger than the area of the sensor electrode, and a part of the conductor facing the sensor electrode.

It is preferable that in the electrostatic capacitance sensor according to Item 1 above, the detection device comprises a detection part for detecting a change in the combined capacitance of the capacitance of the conductor and the capacitance of the sensor electrode as a change in the capacitance of the sensor electrode, and a control part, the detection part comprises a CV amplifier for converting the change in capacitance into a change in voltage, and the control part is configured to detect the contact or approach action of the detectable object with respect to the detection region based on a detection signal corresponding to the change in voltage output from the detection part.

The electrostatic capacitance sensor of the present disclosure also includes an electrostatic capacitance sensor according to Item 2 below as a preferred aspect of the electrostatic capacitance sensor according to Item 1 above.

Item **2.** The electrostatic capacitance sensor according to Item **1,** wherein the conductor is provided over the entire detection region.

The electrostatic capacitance sensor of the present disclosure also includes an electrostatic capacitance sensor according to Item 3 below as a preferred aspect of the electrostatic capacitance sensor according to Items 1 and 2 above.

Item 3. The electrostatic capacitance sensor according to Item 1 or 2, wherein the conductor is composed of any of conductive ink, a conductive resin, a metal film, a metal sheet, a metal plate, a metal mesh, a conductive woven fabric, a conductive knitted fabric, and a conductive non-woven fabric.

The electrostatic capacitance sensor of the present disclosure also includes an electrostatic capacitance sensor according to Item 4 below as a preferred aspect of the electrostatic capacitance sensor according to Items 1 to 3 above.

Item 4. The electrostatic capacitance sensor according to any one of Items 1 to 3, wherein the detection region is a toilet seat,

the conductor is provided on a back side of the toilet seat, and
the sensor electrode is fixed to a part of the conductor via the dielectric.

Advantageous Effects of Invention

The electrostatic capacitance sensor of the present disclosure detects the contact or approach action of a detectable object, such as the user's touch operation, with respect to the detection region by electrostatic induction between a sensor electrode with a smaller area and a conductor with a larger area than the sensor electrode. Therefore, in the electrostatic capacitance sensor of the present disclosure, the conductor plays the role of the sensor electrode in the prior art, and is configured to be sensitive to the approach of a detectable object to the conductor. Consequently, even if the area of the sensor electrode is small, the electrostatic capacitance sensor of the present disclosure can expand the detection range that can be sensitive to the contact or approach action of the detectable object by using the conductor with a larger area.

In addition, the electrostatic capacitance sensor of the present disclosure does not need to increase the area of the sensor electrode in order to expand the detection range that can be sensitive to the contact or approach action of the detectable object, and a sensor electrode with a small area is sufficient, thereby keeping costs low.

In the electrostatic capacitance sensor of the present disclosure, the detection distance of the detectable object from the sensor electrode is the sum of the distance between the conductor and the sensor electrode, and the distance between the conductor and the detectable object, which is larger than the detection distance by a sensor electrode of the same area in the prior art. Therefore, the electrostatic capacitance sensor of the present disclosure can ensure a large detection distance of the detectable object from the sensor electrode, and can sensitively detect the contact or approach action of the detectable object with respect to the detection region even if the detection distance is increased.

The detection range and sensitivity of the electrostatic capacitance sensor of the present disclosure do not depend on the area of the sensor electrode. Therefore, it is not necessary to change the area of the sensor electrode depending on the lineup (detection range and sensitivity) of equipment in which the electrostatic capacitance sensor is installed. In addition, even if the area of the conductor is changed depending on the lineup (detection range and sensitivity) of equipment, the change in capacitance of the sensor electrode due to the contact or approach action of the detectable object with respect to the detection region is small. Therefore, the electrostatic capacitance sensor of the present disclosure can eliminate the need to adjust the capacitance of the sensor electrode for each type of equipment, as well as the parasitic capacitance that depends on the sensor electrode, individual variations, sensitivity, threshold value, etc.

Brief Description of Drawings

Fig. 1 is a diagram illustrating a functional configuration of an electrostatic capacitance sensor according to an embodiment of the present disclosure.

Fig. 2 is a diagram illustrating a functional configuration of an electrostatic capacitance sensor according to an embodiment of the present disclosure.

Fig. 3 is a diagram explaining the operating principle of an electrostatic capacitance sensor according to an embodiment of the present disclosure.

Fig. 4 is a diagram explaining the operating principle of a conventional electrostatic capacitance sensor.

Fig. 5 is a diagram illustrating an example in which the electrostatic capacitance sensor is applied to a toilet seat heater.

Fig. 6 (A) is a diagram illustrating the back side of the toilet seat, and Fig. 6 (B) is a diagram illustrating a cross section of the toilet seat.

Fig. 7 is a diagram illustrating an example in which the electrostatic capacitance sensor is applied to an attendance management system.

Fig. 8 is a diagram illustrating a cross section of the seat of the chair.

Fig. 9 is a diagram illustrating an example in which the electrostatic capacitance sensor is applied to an automatic faucet apparatus.

Fig. 10 (A) is a diagram illustrating a part of the front of the faucet, and Figs. 10 (B) and (C) are diagrams illustrating cross sections of the faucet.

Fig. 11 is a diagram illustrating an example in which the electrostatic capacitance sensor is applied to a lamp, and Fig. 11 (B) is a diagram illustrating a part of a cross section of the lamp.

Fig. 12 (A) is a diagram illustrating an example in which the electrostatic capacitance sensor is applied to a wireless earphone, and Fig. 12 (B) is a diagram illustrating a part of a cross section of the wireless earphone.

Fig. 13 (A) is a diagram illustrating an example in which the electrostatic capacitance sensor is applied to a touch switch, and Fig. 13 (B) is a diagram illustrating a functional configuration of the touch sensor.

Fig. 14 (A) is a diagram illustrating an example in which the electrostatic capacitance sensor is applied to a touch switch, and Fig. 14 (B) is a diagram illustrating a functional configuration of the touch sensor.

Fig. 15 (A) is a diagram illustrating an example in which the electrostatic capacitance sensor is applied to a water level sensor, and Fig. 15 (B) is a diagram illustrating a part of a cross section of the water level sensor.

Fig. 16 is a graph showing the relationship between the water level and capacitance in the water level sensor of **Fig. 15**.

**Fig.** 17 (A) is a circuit diagram when the contact or approach action of a detectable object is not detected in a known invention, and **Fig.** 17 (B) shows the simulation results of measuring the current value (reference current value) flowing through the circuit.

**Fig.** 18 (A) is a circuit diagram when the contact or approach action of a detectable object is detected in the known invention, and **Fig.** 18 (B) shows the simulation results of measuring the current value flowing through the circuit.

Fig. 19 (A) is a circuit diagram that takes into account LCR components when the contact or approach action of a detectable object is not detected in the known invention, and Fig. 19 (B) shows the simulation results of measuring the current value (reference current value) flowing through the circuit.

Fig. 20 (A) is a circuit diagram that takes into account LCR components when the contact or approach action of a detectable object is detected in the known invention, and Fig. 20 (B) shows the simulation results of measuring the current value flowing through the circuit.

Fig. 21 (A) is a circuit diagram when the contact or approach action of a detectable object is not detected in the electrostatic capacitance sensor of the present disclosure, and Fig. 21 (B) shows the simulation results of measuring the voltage value (reference voltage value) of the circuit.

Fig. 22 (A) is a circuit diagram when the contact or approach action of a detectable object is detected in the electrostatic capacitance sensor of the present disclosure, and Fig. 22 (B) shows the simulation results of measuring the voltage value of the circuit.

Fig. 23 (A) is a circuit diagram that takes into account LCR components when the contact or approach action of a detectable object is not detected in the electrostatic capacitance sensor of the present disclosure, and Fig. 23 (B) shows the simulation results of measuring the voltage value (reference voltage value) of the circuit.

Fig. 24 (A) is a circuit diagram that takes into account LCR components and has a calibration that offsets parasitic capacitance when the contact or approach action of a detectable object is not detected in the electrostatic capacitance sensor of the present disclosure, and Fig. 24 (B) shows the simulation results of measuring the voltage value (reference voltage value) of the circuit.

Fig. 25 (A) is a circuit diagram that takes into account LCR components and has a calibration that offsets parasitic capacitance when the contact or approach action of a detectable object is detected in the electrostatic capacitance sensor of the present disclosure, and Fig. 25 (B) shows the simulation results of measuring the voltage value of the circuit.

Description of Embodiments

Overview of Electrostatic Capacitance Sensor and Explanation of Overall Configuration

The electrostatic capacitance sensor of the present disclosure is used to detect the user's touch operation in order to allow, for example, electronic equipment (e.g., information and communication equipment, home appliances, and in-vehicle products) to execute various functions in response to the user's touch operation. The electrostatic capacitance sensor detects changes in the capacitance of the sensor electrode caused by approaching or contacting a detectable object (conductor), such as a part of the user's body or a special input tool such as a touch pen, to the detection region of each type of equipment, thereby determining the presence or absence of a touch operation to the detection region. An embodiment of the electrostatic capacitance sensor of the present disclosure is described below with reference to the attached drawings. The electrostatic capacitance sensor of the present disclosure is not limited to the following embodiment.

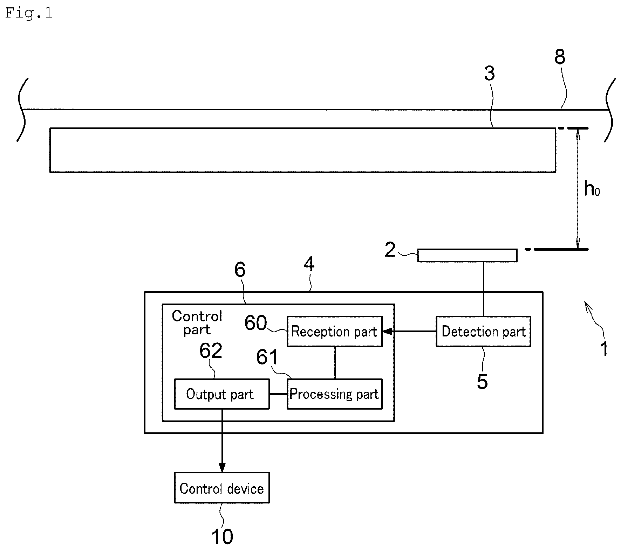

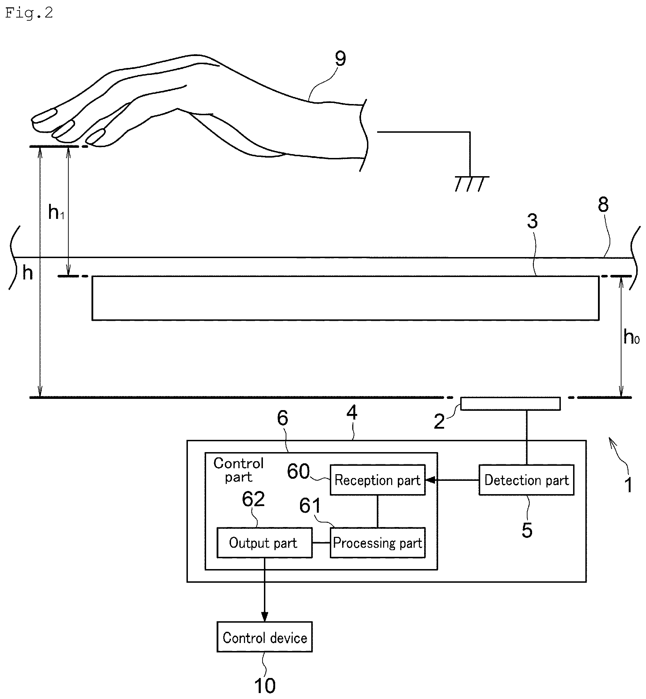

Figs. 1 and 2 show functional configurations of an electrostatic capacitance sensor 1. The electrostatic capacitance sensor 1 comprises a sensor electrode 2, a conductor 3 provided in a detection region 8 that receives the user's touch operation in the equipment, and a detection device 4 that determines the presence or absence of a touch operation to the detection region 8 based on changes in the capacitance of the sensor electrode 2.

Explanation of Sensor Electrode

The sensor electrode 2 is conventionally known and can be formed from a material that has conventionally been used for sensor electrodes of electrostatic capacitance sensors. Examples of such materials include carbons, such as graphite and carbon black; metals, such as aluminum, copper, silver, and gold; conductive resins, such as thiophene-based conductive polymers and polystyrene sulfonate (PSS); and composite materials thereof.

The sensor electrode 2 has the form of a planar body, such as a plate or sheet, and its external shape is, for example, rectangular or circular. The size of the sensor electrode 2 is not particularly limited, but is 3 mm or more and 80 mm or less in length and 3 mm or more and 80 mm or less in width (in the case of a circle, the diameter is 3 mm or more and 80 mm or less), and preferably 3 mm or more and 20 mm or less in length and 3 mm or more and 20 mm or less in width (in the case of a circle, the diameter is 3 mm or more and 20 mm or less). The sensor electrode 2 is formed so that the area of the main surface (the area when viewed from the direction in which the sensor electrode 2 and the conductor 3 face each other, as described below) is small.

A positive voltage with respect to the ground is applied to the sensor electrode 2 by a power source (not shown). As a result, a plus charge (positive charge) is generated uniformly on the sensor electrode 2.

Explanation of Conductor

The conductor 3 can be formed from carbon, such as graphite or carbon black; metal, such as aluminum, copper, silver, or gold; a conductive resin, such as a thiophene-based conductive polymer or polystyrene sulfonate (PSS); conductive ink; conductive fibers, such as chemical fibers containing metal or carbon, chemical fibers with a metal surface coating, or metal fibers made from metal; or a composite material thereof.

The conductor 3 has the form of a planar body, such as a plate, sheet, or film. The conductor 3 is not particularly limited, but preferably can be a metal film (including plating and vapor deposition), a metal sheet (including metal foil), a metal plate, a metal net, or a woven fabric (including mesh), knitted fabric, or nonwoven fabric formed from conductive fibers.

The conductor 3 is provided in the detection region 8 included in the equipment. The conductor 3 may be provided on a side of the detection region 8 to be touched by the user, or on a side opposite to the side to be touched by the user.

The conductor 3 is disposed opposite the sensor electrode 2, i.e., with their main surfaces facing each other. The conductor 3 is disposed apart from the sensor electrode 2 with air interposed therebetween, or disposed to have a dielectric, such as an insulator, interposed between the conductor 3 and the sensor electrode 2.

The outer shape of the conductor 3 is, for example, rectangular or circular. The conductor 3 is formed so as to have a larger area than the sensor electrode 2 when viewed from the direction in which the sensor electrode 2 and the conductor 3 face each other, and the sensor electrode 2 faces a part of the conductor 3.

The conductor 3 is not particularly limited in size, but is preferably large enough to be provided over the entire (or almost the entire) detection region **8.** This allows the entire detection region 8 to be sensitive to the user's touch operation.

The conductor 3 is disposed so that its part is located within the electric field generated by the sensor electrode **2.** When a part of the conductor 3 is present within the electric field, the conductor 3 undergoes electrostatic induction to cause polarization. Then, a different type of minus charge (negative charge) is generated in a part of the conductor 3 close to the sensor electrode 2 due to the attraction of the positive charge of the sensor electrode 2, and an equal amount of positive charge is generated in a part of the conductor 3 far from the sensor electrode 2.

The smaller the distance $h_0$ between the conductor 3 and the sensor electrode 2, the more likely electrostatic induction occurs, and the greater the amount of negative charge generated in the conductor 3; thus, the greater the amount of positive charge generated in the conductor 3 as well. Therefore, since the electric field generated between the part of the conductor 3 where a positive charge is generated and the ground increases, the distance $h_0$ between the conductor 3 and the sensor electrode 2 is preferably short.

Regarding the positional relationship between the conductor 3 and the sensor electrode 2, the conductor 3 is positioned on the side to be touched by the user relative to the sensor electrode 2; however, the sensor electrode 2 may be positioned on the side to be touched by the user relative to the conductor 3.

Explanation of Change in Capacitance by User's Touch Operation

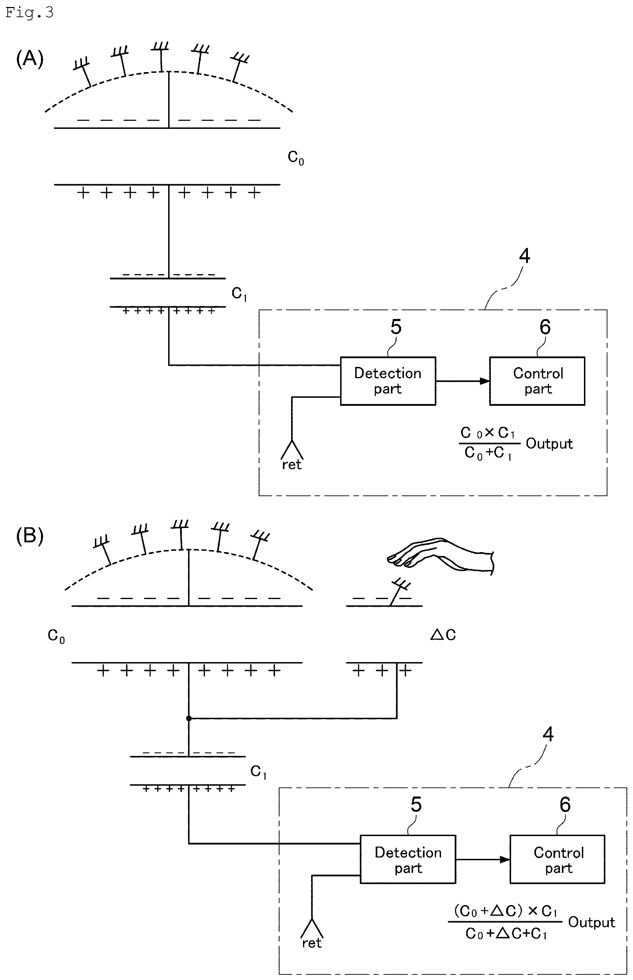

As shown in Figs. 1 and 3 (A), in the absence of the user's touch operation to the detection region 8, when the capacitance of the conductor 3 is taken as $C_0$, and the capacitance of the sensor electrode 2 is taken as $C_1$ ($C_1 < C_0$), $C_0$ and $C_1$ are connected in series in the present disclosure; thus, the combined capacitance of the sensor electrode 2 is $C_0 \times C_1/(C_0+C_1)$. The capacitance $C_0 \times C_1/(C_0+C_1)$ is monitored by the detection device 4. The combined capacitance $C_0 \times C_1/(C_0+C_1)$ of the sensor electrode 2 is the combined capacitance of the capacitance $C_0$ of the conductor 3 and the $C_1$ capacitance of the sensor electrode 2.

In contrast, as shown in Figs. 2 and 3 (B), when the user lets a detectable object 9, such as a part of the user's body (e.g., a finger), approach or be in contact with the detection region 8 for the touch operation (when the distance $h_1$ between the conductor 3 and the detectable object 9 is reduced), the detectable object 9 interferes with the electric field from the conductor 3. Since the user's body is grounded, charges are collected through the user's body, which acts as a conductor, and the capacitance of the conductor 3 changes from $C_0$ to $C_0+\Delta C$. When the capacitance (charge) of the conductor 3 changes to $C_0+\Delta C$, the combined capacitance of the sensor electrode 2, that is, the combined capacitance of the capacitance $C_0+\Delta C$ of the conductor 3 and the capacitance $C_1$ of the sensor electrode 2, is $(C_0+\Delta C) \times C_1/\{(C_0+\Delta C)+C_1\}$. Therefore, where the user touches the detection region 8, the change in the capacitance $\Delta C'$ of the sensor electrode 2 of the present disclosure, that is, the change in the combined capacitance of the capacitance of the conductor 3 and the capacitance of the sensor electrode 2, is as shown in the following equation 1, and the change in the capacitance $\Delta C'$ of the sensor electrode 2 is detected by the detection device 4.

[Equation 1]

$$\Delta C' = (C_0+\Delta C) \times C_1/\{(C_0+\Delta C)+C_1\} - C_0 \times C_1/(C_0+C_1) = \Delta C \times C_1^2/\{(C_0+C_1) \times (C_0+\Delta C+C_1)\}$$

Since the change in the capacitance $\Delta C'$ of the sensor electrode 2 of the present disclosure is the denominator of equation 1, $(C_0+C_1) \times (C_0+\Delta C+C_1)=C_0^2+2C_0C_1+C_0\Delta C+C_1\Delta C+C_1^2>C_1^2$, $C_1^2/\{(C_0+C_1)\times(C_0+\Delta C+C_1)\}$ of equation 1 is less than 1. Therefore, $\Delta C'$ is less than $\Delta C$.

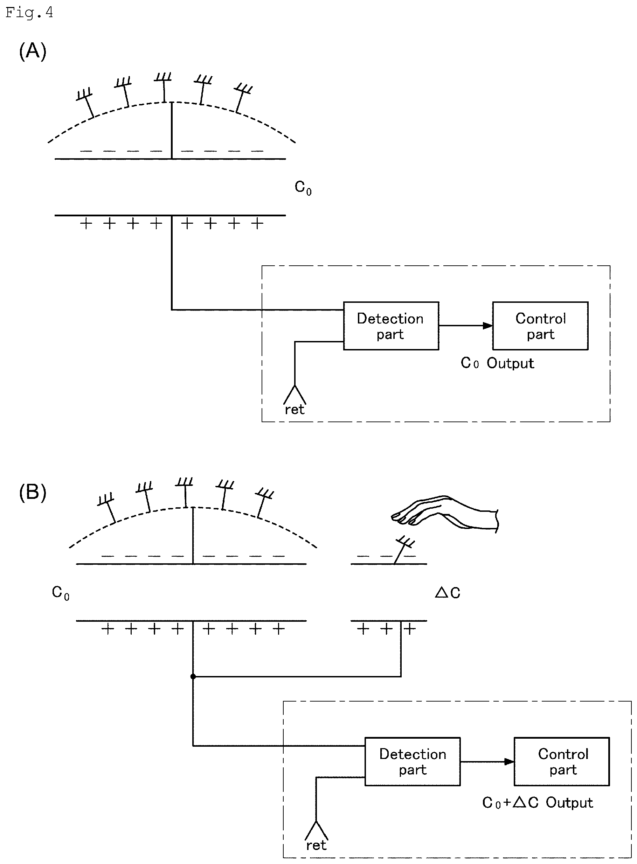

In an electrostatic capacitance sensor of the prior art, when the user's touch operation is detected by a sensor electrode of the same area as the conductor 3 of the electrostatic capacitance sensor 1 of the present disclosure, the change in the capacitance of the sensor electrode due to the user's touch operation is $(C_0+\Delta C)-C_0=\Delta C$, as shown in Figs. 4 (A) and (B). Therefore, it can be seen that in the electrostatic capacitance sensor 1 of the present disclosure, the amount of change in the capacitance of the sensor electrode 2 due to the user's touch operation is smaller than that of the prior art.

Explanation of Detection Device

The capacitance of the sensor electrode 2 changes depending on the distance $h_1$ between the conductor 3 and the detectable object 9 when the user approaches or contacts the detectable object 9 to the conductor 3 in the detection region 8. The detection device 4 includes a detection part 5 that detects changes in the capacitance of the sensor electrode 2.

The detection part 5 is electrically connected to the sensor electrode 2. The detection part 5 has an electrical/-electronic circuit for detecting changes in the capacitance of the sensor electrode 2. In order to detect changes in the capacitance of the sensor electrode 2, the detection part 5 can be composed of, for example, a CV amplifier that converts the change in capacitance into a change in voltage, and a detection circuit having a CV amplifier gain adjustment function to adjust sensitivity. When there is no user's touch operation to the detection region 8, no detectable object 9 is present within the electric field of the conductor 3, so there is no change in capacitance or no change in voltage from the CV amplifier. On the other hand, when the detectable object 9 interferes with the electric field of the conductor 3 due to the user's touch operation to the detection region 8, the capacitance of the sensor electrode 2 increases, and a change in voltage corresponding to the increase in capacitance from the CV amplifier is multiplied by a gain and output from the detection circuit. The detection signal may be in the form of analog data or digital data.

The method for detecting changes in the capacitance of the sensor electrode 2 using the detection part 5 is not limited to the above example, and various conventionally known methods can be used, such as (1) a method of measuring the time difference required for discharging after charging the sensor electrode 2 with a fixed charge, and (2) a method of detecting changes in the capacitance of the sensor electrode 2 based on changes in the oscillation state of the oscillator circuit. The detection part 5 can be composed of an electrical/electronic circuit, a switch, and the like that are used in conventionally known electrostatic capacitance sensors suitable for the methods (1) and (2).

The detection device 4 includes a control part 6 that determines that there has been a touch operation to the detection region 8 based on the detection signal output from the detection part 5. The control part 6 can be composed of a microcomputer, for example. The control part 6 includes a reception part 60, a processing part 61, an output part 62, and the like.

The reception part 60 is configured as an interface that receives the detection signal. When the detection signal is in the form of analog data, the reception part is configured to include an appropriate conversion circuit including an A/D converter. The processing part 61 is configured to determine the presence or absence of a touch operation to the detection region 8 based on the detection signal. For example, when the processing part 61 determines that the amount of change in the capacitance of the sensor electrode 2 exceeds a predetermined threshold value stored in a memory, it determines that there has been a touch operation to the detection region **8**. The output part 62 is configured as an interface that outputs a control signal to allow the control device 10 installed in the equipment to execute the function of each type of equipment. The processing part 61 is configured to output a control signal from the output part 62 when it determines that there has been a touch operation to the detection region 8. The control signal may be in the form of analog data or digital data. When the control signal is in the form of analog data, the output part is configured to include an appropriate conversion circuit including a D/A converter.

The detection device 4 may be in the form of a module 7 incorporating the sensor electrode 2, or may be in a form separate from the sensor electrode 2.

Actions and Effects of Electrostatic Capacitance Sensor

According to the electrostatic capacitance sensor 1 of the present embodiment described above, the user's touch operation to the detection region 8 is detected by electrostatic induction between the sensor electrode 2 with a smaller area and the conductor 3 with a larger area than that of the sensor electrode 2. Therefore, in the electrostatic capacitance sensor 1 of the present embodiment, the conductor 3 serves as the sensor electrode in the prior art, and is configured to be sensitive to the approach of the detectable object 9 to the conductor 3. Consequently, even if the area of the sensor electrode 2 is small, the electrostatic capacitance sensor 1 of the present disclosure can expand the detection range that can be sensitive to the user's touch operation by using the conductor 3 with a larger area.

In addition, the electrostatic capacitance sensor 1 of the present embodiment does not need to increase the area of the sensor electrode 2 in order to expand the detection range that can be sensitive to the user's touch operation, and the sensor electrode 2 with a small area is sufficient, thereby keeping costs low.

In the electrostatic capacitance sensor 1 of the present embodiment, the detection distance h of the detectable object 9 from the sensor electrode 2 (shown in Fig. 2) is the sum of the distance $h_0$ between the conductor 3 and the sensor electrode 2, and the distance $h_1$ between the conductor 3 and the detectable object 9, and is larger than the detection distance $h_0$ by the sensor electrode of the same area in the prior art. Therefore, the electrostatic capacitance sensor 1 of the present embodiment can ensure a large detection distance h of the detectable object 9 from the sensor electrode 2, and can detect the user's touch operation to the detection region 8 with high sensitivity even if the detection distance h is increased.

In the electrostatic capacitance sensor 1 of the present embodiment, the detection range and sensitivity do not depend on the area of the sensor electrode 2. Therefore, it is not necessary to change the area of the sensor electrode 2 depending on the lineup (detection range and sensitivity) of equipment in which the electrostatic capacitance sensor is installed. In addition, even if the area of the conductor 3 changes depending on the lineup (detection range and sensitivity) of equipment, there is a small change in the capacitance of the sensor electrode 2 due to the user's touch operation to the detection region. Therefore, the electrostatic capacitance sensor 1 of the present embodiment can eliminate the need to adjust the capacitance of the sensor electrode 2 for each type of equipment, as well as the parasitic capacitance that depends on the sensor electrode 2, individual variations, sensitivity, threshold value, etc.

In the electrostatic capacitance sensor 1 of the present embodiment, the combined capacitance $C_0 \times C_1/(C_0+C_1)$ of the capacitance $C_0$ of the conductor 3 and the capacitance $C_1$ of the sensor electrode 2 is detected to detect the contact or approach action of the detectable object. As with the capacitance type touch sensor disclosed in JP2021-99297A (hereinafter referred to as "the known invention"), when the total value $C_0+C_1$ of the capacitance $C_0$ (Cs1 in JP2021-99297A) of a conductor (metallic sheet 2 in JP2021-99297A) and the capacitance $C_1$ (Cs2 in JP2021-99297A) of a sensor electrode (detection electrode 3 in JP2021-99297A) is detected, if the capacitance of the conductor

increases to $C_0+\Delta C$ due to the contact or approach action of the detectable object, the total capacitance detected when the detectable object makes a contact or approach action is $C_0+\Delta C+C_1$. Therefore, in the known invention, the change in capacitance before and after the contact or approach action of the detectable object is $C_0+\Delta C+C_1-(C_0+C_1)=\Delta C$. This directly detects the change $\Delta C$ in the capacitance of the conductor that increases due to the contact or approach action of the detectable object.

In contrast, in the electrostatic capacitance sensor 1 of the present embodiment, since the combined capacitance of the capacitance $C_0$ of the conductor and the capacitance $C_1$ of the sensor electrode is detected, when the capacitance of the conductor increases to $C_0+\Delta C$ due to the contact or approach action of the detectable object, the combined capacitance of their capacitances detected when the detectable object makes a contact or approach action is $(C_0+\Delta C)\times C_1/\{(C_0+\Delta C)+C_1)\}$. Therefore, in the electrostatic capacitance sensor 1 of the present embodiment, the change in capacitance before and after the contact or approach action of the detectable object is $\Delta C\times C_1^2/\{(C_0+C_1)\times(C_0+\Delta C+C_1)\}=\Delta C'$, and as described above, this $\Delta C'$ is smaller than the change in the capacitance $\Delta C$ of the conductor that increases due to the contact or approach action of the detectable object. Thus, the electrostatic capacitance sensor 1 of the present embodiment can detect the amount of change in capacitance caused by the contact or approach action of the detectable object in a reduced scale, thereby achieving the following actions and effects.

(1) Since the amount of change in capacitance caused by the contact or approach action of the detectable object can be detected in a reduced scale, large changes in capacitance on the conductor side can be detected with a small dynamic range.
(2) An electrostatic capacitance sensor with a small dynamic range is sufficient, which leads to a cost reduction.
(3) Since the change in capacitance due to temperature changes on the conductor side becomes smaller, it becomes less susceptible to external disturbances.
(4) The same sensor electrode can be used in place of a wide variety of directly connected conductors.
(5) It is possible to reduce the capacitance of a capacitor or the like provided as a voltage detection part, described below, in the detection device.

In the electrostatic capacitance sensor 1 of the present embodiment, the change in capacitance is converted into a change in voltage, and the contact or approach action of the detectable object is detected based on the change in voltage. In the known invention described above, the capacitor is charged and discharged by switch operation, and the current value flowing through the circuit when the capacitor is discharged is detected by a current detection part. In contrast to converting the change in capacitance into a change in current and detecting the contact or approach action of the detectable object based on the change in current, as in the known invention, the electrostatic capacitance sensor 1 of the present embodiment has the following actions and effects.

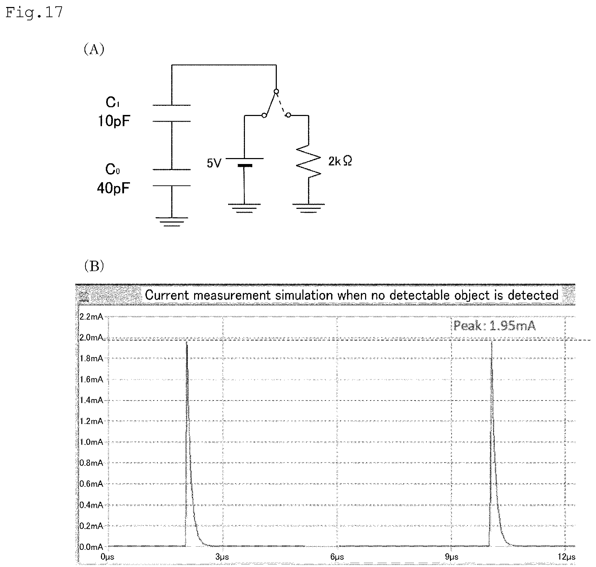

In the known invention, when no contact or approach action of the detectable object is detected, Fig. 17 (B) shows the simulation results of measuring the current value (reference current value) flowing through the circuit, with the capacitance $C_0$ of the conductor being 40 pF, the capacitance $C_1$ of the sensor electrode being 10 pF, the voltage of the power supply being 5 V, and the resistance of a resistor, which is used as the current detection part, being 2 k$\Omega$, as shown in Fig. 17 (A). According to Fig. 17 (B), 1.95 mA is detected as the peak reference current value.

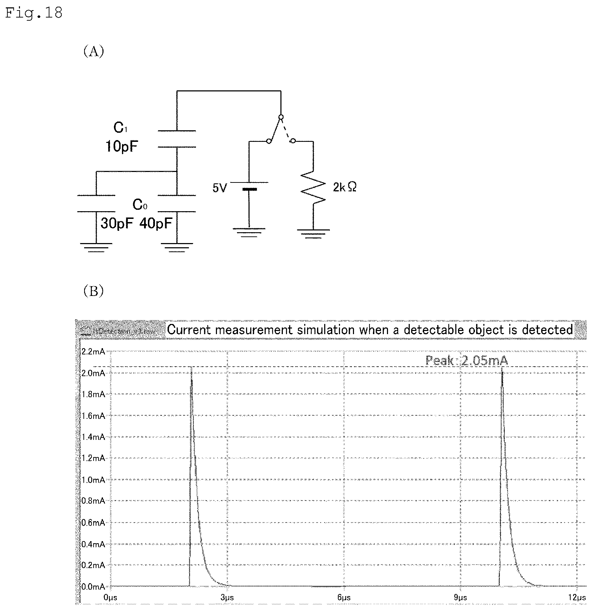

On the other hand, in the known invention, when the contact or approach action of the detectable object is detected, Fig. 18 (B) shows the simulation results of measuring the current value flowing through the circuit, with the increase in the capacitance $C_0$ of the conductor due to the contact or approach action of the detectable object being 30 pF, as shown in Fig. 18 (A). According to Fig. 18 (B), 2.05 mA is detected as the peak current value.

Thus, in the known invention, for example, the threshold current value can be set in the range of greater than 1.96 mA and less than 2.05 mA, and the amount of change in current from the reference current value of 1.95 mA can be set to, for example, about 0.1 mA, making it possible to detect the contact or approach action of the detectable object in a simulation.

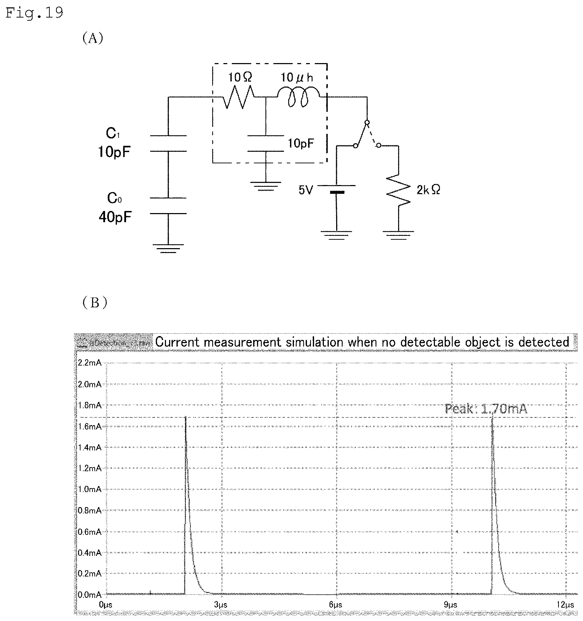

However, it would have been obvious to a person skilled in the art that in the environment in which the touch sensor is actually operated, invisible LCR components, such as parasitic capacitance, parasitic inductance, and parasitic resistance, occur between the detection electrode and the detection part due to the influence of the substrate, conductor wire, etc. In the known invention, in the actual operating environment, as shown in Fig. 19 (A), LCR components, such as parasitic capacitance, parasitic inductance, and parasitic resistance (the part surrounded by the two-dot chain line in Fig. 19 (A)), occur between the detection electrode and the current detection part. Therefore, in order for the touch sensor to actually work, it is necessary to take into account these LCR components as well.

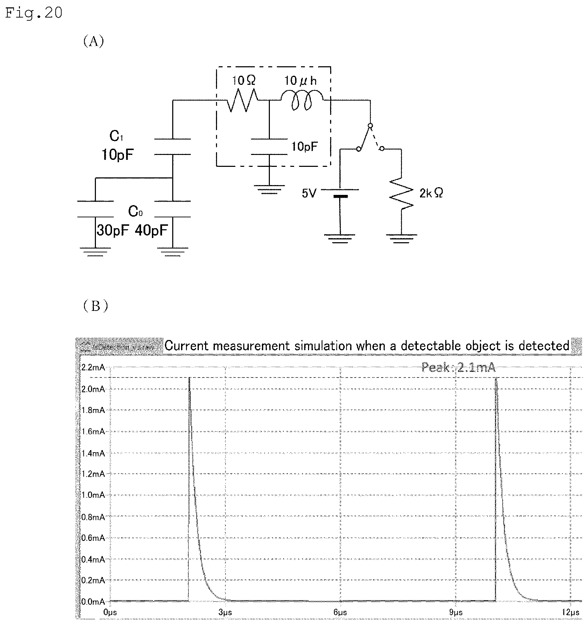

Fig. 19 (B) shows the simulation results of measuring the reference current value flowing through the circuit when no contact or approach action of the detectable object is detected, with the parasitic capacitance being 10 pF, the parasitic inductance being 10 $\mu$h, and the parasitic resistance being 10 Q. According to Fig. 19 (B), 1.70 mA is detected as the peak reference current value. Further, Fig. 20 (B) shows the simulation results of measuring the reference current value flowing through the circuit when the contact or approach action of the detectable object is detected, with the parasitic capacitance being 10 pF, the parasitic inductance being 10 $\mu$h, and the parasitic resistance being 10 $\Omega$, as shown in Fig. 20 (A). According to Fig. 20 (B), 2.1 mA is detected as the peak current value.

Thus, in the known invention, when taking into account the actual operating environment, the reference current value detected when no detectable object is detected changes from 1.95 mA to 1.7 mA, the current value when a detectable object is detected also changes from 2.05 mA to 2.1 mA. Regarding the current value when a detectable object is detected, the amount of change in current from the reference current value also changes from 0.1 mA to 0.4 mA. Since the current value taking into account the actual operating environment described above varies depending on the individual operating environment, if the contact or approach action of the detectable object is detected based on the current value, it is not possible to set an appropriate threshold value etc. in the current detection part, and it is also not possible to specify the detected current value or amount of change in current to determine whether the detectable object makes a contact or approach action.

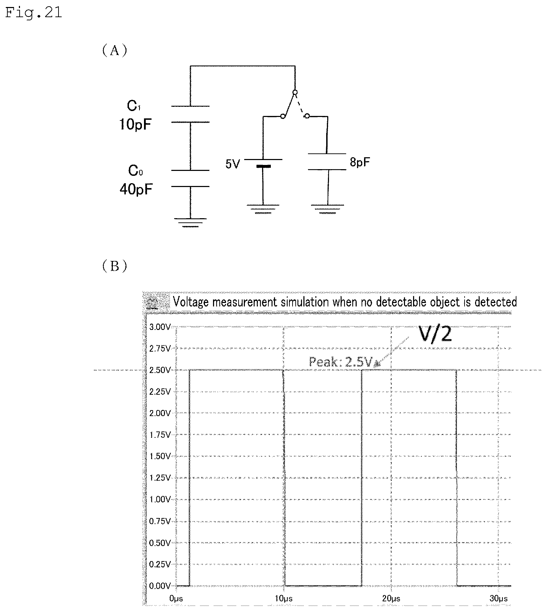

In contrast, the electrostatic capacitance sensor 1 of the present embodiment converts the change in capacitance to a change in voltage, and detects the contact or approach action of the detectable object based on the change in voltage. When no contact or approach of the detectable object is detected, Fig. 21 (B) shows the simulation results of measuring the voltage value (reference voltage value), with the capacitance $C_0$ of the conductor being 40 pF, the capacitance $C_1$ of the sensor electrode being 10 pF, the voltage of the power supply being 5 V, and the resistance of a capacitor, which is used as the voltage detection part, being 8 pF (the same value as the combined capacitance of $C_0$ and $C_1$), as shown in Fig. 21 (A). According to Fig. 21 (B), 2.5 V is detected as the peak reference voltage value.

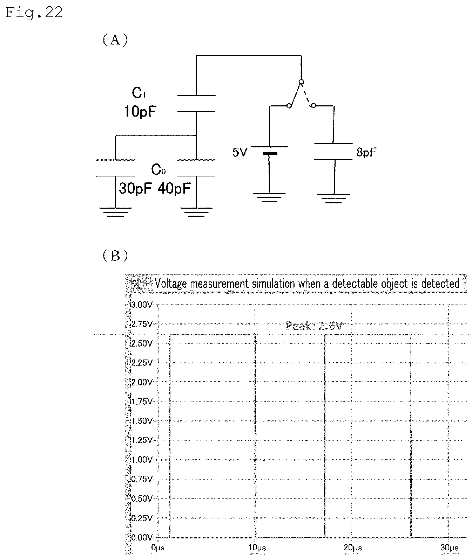

On the other hand, as shown in Fig. 22 (A), when the contact or approach action of the detectable object is detected, Fig. 22 (B) shows the simulation results of measuring the voltage value, with the increase in the capacitance $C_0$ of the conductor due to the contact or approach action of the detectable object being 30 pF. According to Fig. 22 (B), 2.6 V is detected as the peak voltage value.

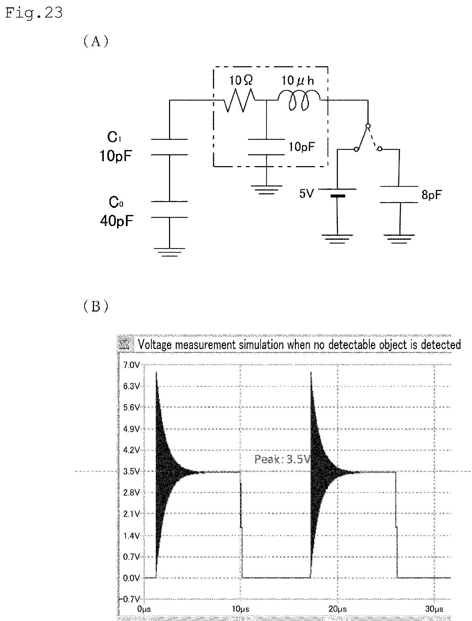

Even when the change in capacitance is converted into a change in voltage, taking into account LCR components, such as parasitic capacitance, parasitic inductance, and parasitic resistance, in the actual operating environment, Fig. 23 (B) shows the simulation results of measuring the reference voltage value when the contact or approach action of the detectable object is not detected, with the parasitic capacitance being 10 pF, the parasitic inductance being 10 $\mu$h, and the parasitic resistance being 10 $\Omega$, as shown in Fig. 23 (A). According to Fig. 23 (B), 3.5 V is detected as the peak reference voltage value.

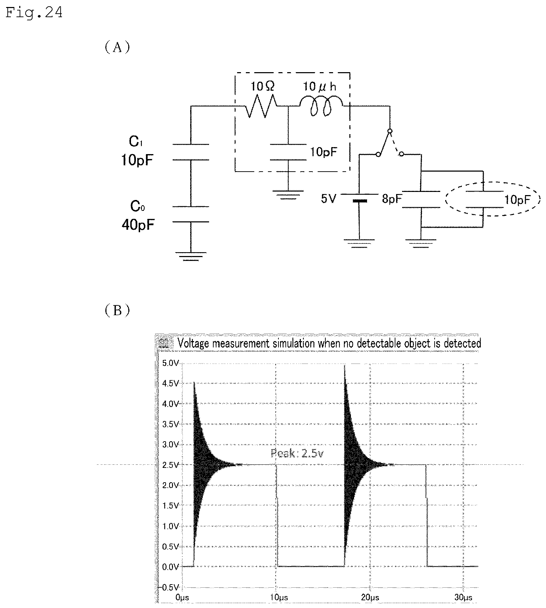

Even when the change in capacitance is converted into a change in voltage, taking into account the actual operating environment, the reference voltage value detected when no detectable object is detected changes from 2.5 V to 3.5 **V.** This change is based on the parasitic capacitance. Therefore, by allowing the circuit to have a calibration that offsets parasitic capacitance, the deviation in the voltage detection value in the actual operating environment can be eliminated. For example, by providing a capacitor (the part surrounded by the dashed line in Fig. 24 (A)) for the calibration of the parasitic capacitance 10 pF, as shown in Fig. 24 (A), the deviation in the voltage detection value in the actual operating environment can be eliminated. Fig. 24 (B) shows the simulation results of measuring the reference voltage value when providing a capacitor for calibration. According to Fig. 24 (B), 2.5 V is detected as the peak reference voltage value, and the deviation in the voltage detection value has been eliminated.

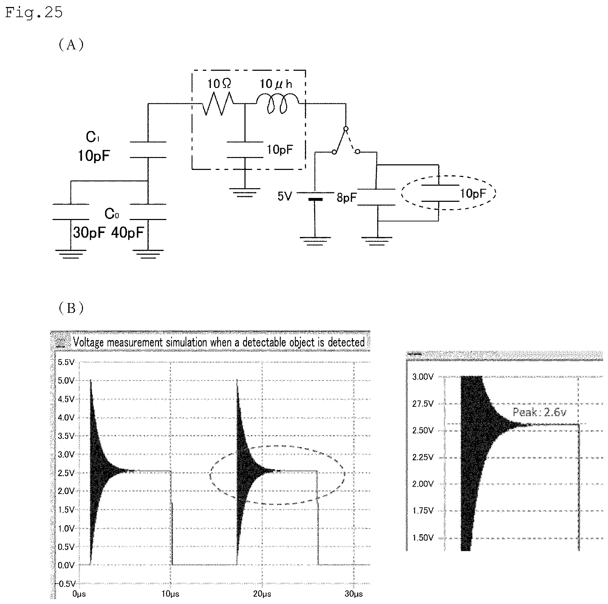

Further, regarding the voltage value when the contact or approach action of the detectable object is detected, Fig. 25 (B) shows the simulation results of measurement when providing a capacitor (the part surrounded by the dashed line in Fig. 25 (A)) for the calibration of the parasitic capacitance 10 pF, as shown in Fig. 25 (A). According to Fig. 25 (B), 2.6 V is detected as the peak voltage value, which is the same as the peak voltage value of 2.6 V in Fig. 22 (B). Even when taking into account the actual operating environment, the voltage value when a detectable object is detected can be made the same value.

As described above, by converting the change in capacitance into a change in voltage and detecting the contact or approach action of the detectable object based on the change in voltage, as with the electrostatic capacitance sensor 1 of the present embodiment, it is possible to set an appropriate threshold value etc. in the detection device even if the actual environment changes, and to appropriately determine whether the detectable object is making a contact or approach action.

In the known invention, the means and method for eliminating the deviation in the current detection value caused by the influence of the actual operating environment are neither disclosed nor suggested in JP2021-99297A, and are not easily recognizable even when referring to common technical knowledge at the time of filing.

Explanation of Use Cases of Electrostatic Capacitance Sensor

Next, examples of using the electrostatic capacitance sensor 1 of the present disclosure in various types of equipment are explained. The applications of the electrostatic capacitance sensor of the present disclosure are not limited to the following examples.

(1) Toilet Seat Heater

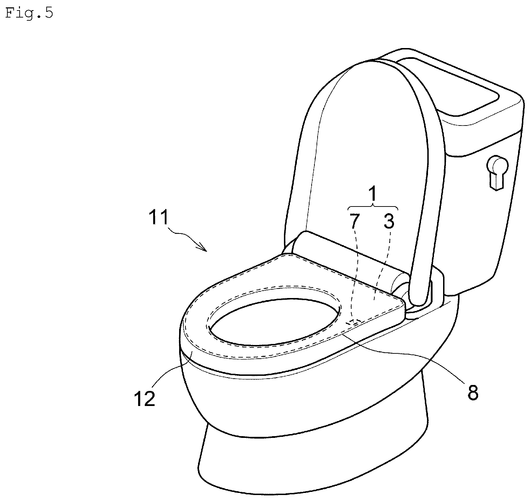

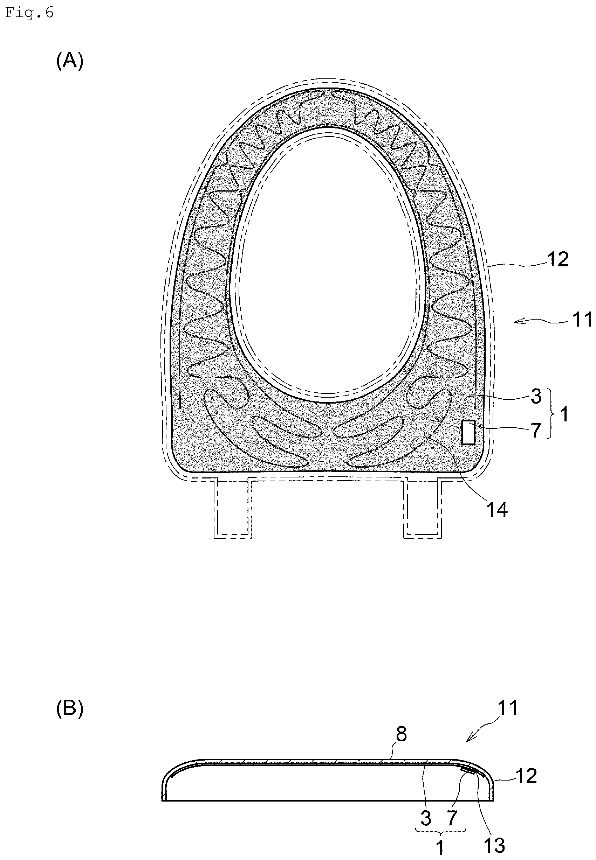

Figs. 5 and 6 show an example in which the electrostatic capacitance sensor 1 is used in a toilet seat heater 11. In the toilet seat heater 11 of the illustrated example, the toilet seat 12 is a detection region 8 that detects the user's touch operation, and it is configured to drive a heater in response to the electrostatic capacitance sensor 1 detecting the action of the user sitting on the toilet seat 12 as the touch operation. In the illustrated example, the sensor electrode 2 and detection device 4 of the electrostatic capacitance sensor 1 are in the form of a module 7 in which the sensor electrode 2 is incorporated into the detection device 4.

The toilet seat 12 is made of synthetic resin. As a conductor 3, for example, an aluminum sheet (aluminum foil) is attached to the entire back side of the toilet seat 12, and the module 7 is attached to a part of the conductor 3 via a dielectric, such as an adhesive or double-sided tape 13. The module 7 is disposed at the rear end of the detection region 8. In addition, a heater wire (cord heater) 14 is laid on the back side of the toilet seat 12. The heater wire 14 is connected to a control device that controls the operation of the toilet seat heater 11, and the control device controls the supply of electricity to the heater wire 14 using a known electrical/electronic circuit, switch, etc.

When the user sits on the toilet seat 12, since the conductor 3 is provided over the entire area of the toilet seat 12, which is the detection region 8, the capacitance of the conductor 3 increases, and the capacitance of the sensor electrode 2 also increases. This change in the capacitance of the sensor electrode 2 is detected by the detection device 4, whereby the electrostatic capacitance sensor 1 detects the user's touch operation to the detection region 8. This detection information is transmitted by wire or wirelessly as a control signal to the control device of the toilet seat heater 11, whereby the control device of the toilet seat heater 11 heats the heater wire 14 to perform the heating function of the toilet seat. On the other hand, when the user gets up from the toilet seat 12, the capacitance of the conductor 3 decreases, and the capacitance of the sensor electrode 2 also decreases. This change in the capacitance of the sensor electrode 2 is detected by the detection device 4, whereby the electrostatic capacitance sensor 1 detects the release of the user's touch operation to the detection region 8. This detection information is transmitted by wire or wirelessly as a control signal to the control device of the toilet seat heater 11, whereby the control device of the toilet seat heater 11 stops the heat generation from the heater wire 14 to stop the heating function of the toilet seat.

In this example, in place of the control device of the toilet seat heater 11, the control part 6 of the detection device 4 may be configured to heat the heater wire 14 to perform the heating function of the toilet seat upon detection of the user's touch operation to the detection region 8.

(2) Attendance Management System

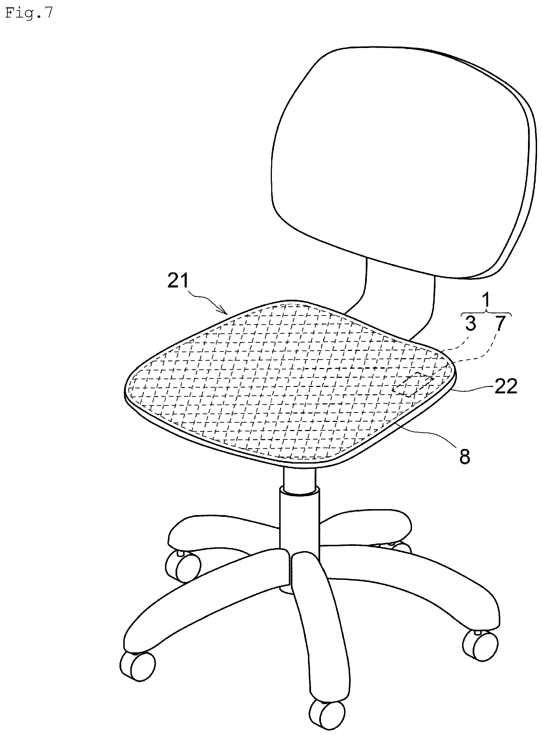

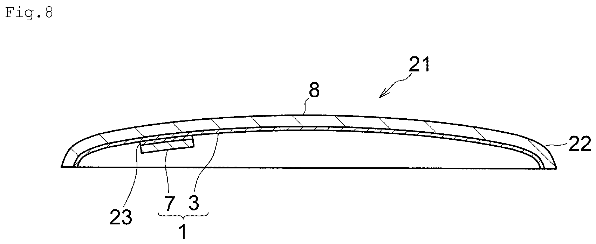

Figs. 7 and 8 show an example in which the electrostatic capacitance sensor 1 is used in an attendance management system 21. In the attendance management system 21 of the illustrated example, the seat 22 of the chair is a detection region 8 that detects the user's touch operation, and it is configured to check the attendance in response to the electrostatic capacitance sensor 1 detecting the action of the user sitting on the seat 22 of the chair as the touch operation. In the illustrated example, the sensor electrode 2 and detection device 4 of the electrostatic capacitance sensor 1 are in the form of a module 7 in which the sensor electrode 2 is incorporated into the detection device 4.

The seat 22 is made of synthetic leather or fabric. As a conductor 3, for example, a conductive mesh fabric is attached to the entire underside of the seat 2, and the module 7 is attached to a part of the conductor 3 via a dielectric, such as an adhesive or double-sided tape 23. The module 7 is disposed at a lateral end of the detection region 8.

When the user sits on the seat 22, since the conductor 3 is provided over the entire area of the seat 22, which is the detection region 8, the capacitance of the conductor 3 increases, and the capacitance of the sensor electrode 2 also increases. This change in the capacitance of the sensor electrode 2 is detected by the detection device 4, whereby the electrostatic capacitance sensor 1 detects the user's touch operation to the detection region 8. This detection information is transmitted by wire or wirelessly as a control signal to the control device (not shown) of the attendance management system, whereby the control device of the attendance management system 21 checks the attendance. On the other hand, when the user gets up from the seat 22, the capacitance of the conductor 3 decreases, and the capacitance of the sensor electrode 2 also decreases. This change in the capacitance of the sensor electrode 2 is detected by the detection device 4, whereby the electrostatic capacitance sensor 1 detects the release of the user's touch operation to the detection region 8. This detection information is transmitted by wire or wirelessly as a control signal to the control device of the attendance management system 21, whereby the control device of the attendance management system 21 checks the attendance.

(3) Automatic Faucet Apparatus

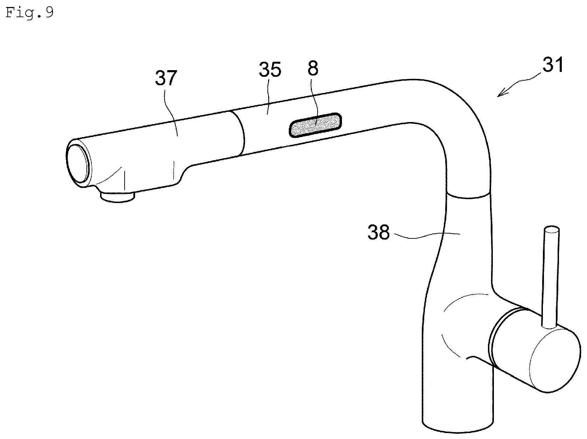

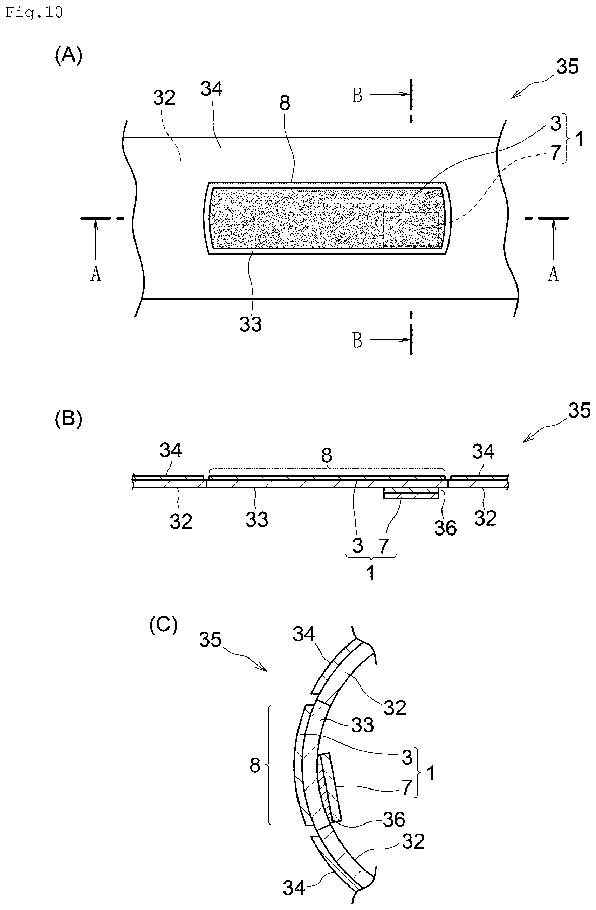

Figs. 9 and 10 show an example in which the electrostatic capacitance sensor 1 is used in an automatic faucet apparatus 31. The automatic faucet apparatus 31 of the illustrated example comprises a water discharge part 37, a water guide part 35, and a handle part 38, and a portion of the water guide part 35 is a detection region 8 that detects the user's touch operation. The automatic faucet apparatus 31 is configured to discharge water from the water discharge part 37 in response to the electrostatic capacitance sensor 1 detecting the action of the user approaching the hand to the water guide part 35 as the touch operation. In the illustrated example, the sensor electrode 2 and detection device 4 of the electrostatic capacitance sensor 1 are in the form of a module 7 in which the sensor electrode 2 is incorporated into the detection device 4.

A portion 32 of the water guide part 35 other than the detection region 8 is made of an alloy, such as brass, or synthetic resin, such as ABS resin, and its outer surface is coated with metal plating 34, such as chrome plating. A portion 33 of the detection region 8 in the water guide part 35 is made of synthetic resin, and the outer surface of the portion 33 is coated with, for example, metal plating as a conductor 3. A clearance is provided between the metal plating 34 on the outer surface of the portion 32 of the water guide part 35 other than the detection region 8 and the conductor 3 on the outer surface of the portion 33 of the detection region 8, and the metal plating 34 is electrically disconnected from the conductor 3 and is preferably grounded. The module 7 is attached to the inner surface of the portion 33 of the detection region 8 in the conductor 3 via a dielectric, such as an adhesive or double-sided tape 36, so as to face a part of the conductor 3. The module 7 is disposed at a corner on the lower end of the detection region 8. In addition, a solenoid valve is provided in the water supply line within the automatic faucet apparatus 31. The solenoid valve is connected to a control device that controls the operation of the automatic faucet apparatus 31, and the control device controls the opening and closing of the solenoid valve.

When the user approaches the hand to the detection region 8, which is a portion of the water guide part 35, since the conductor 3 is provided over the entire detection region 8, the capacitance of the conductor 3 increases, and the capacitance of the sensor electrode 2 also increases. This change in the capacitance of the sensor electrode 2 is detected by the detection device 4, whereby the electrostatic capacitance sensor 1 detects the user's touch operation to the detection region 8. This detection information is transmitted by wire or wirelessly as a control signal to the control device of the automatic faucet apparatus 31, whereby the control device of the automatic faucet apparatus 31 opens the solenoid valve to discharge water. After water is discharged for a predetermined period of time, the control device of the automatic faucet apparatus 31 closes the solenoid valve to stop the water flow.

In Figs. 9 and 10, a portion of the water guide part 35 serves as the detection region 8; however, the entire water guide part 35 can be used as the detection region 8. In this case, the entire outer surface of the water guide part 35 is covered with metal plating as the conductor 3. A clearance is provided between the metal plating covering the outer surface of the water discharge part 37 and handle part 38, and the conductor 3 on the outer surface of the water guide part 35 so that the water discharge part 37 and the handle part 38 are electrically disconnected from the water guide part 35. The metal plating on the outer surface of the water discharge part 37 and handle part 38 is preferably grounded.

In the example in which the electrostatic capacitance sensor 1 is used in the automatic faucet apparatus 31, in place of the control device of the automatic faucet apparatus 31, the control part 6 of the detection device 4 may be configured to open and close the solenoid valve to turn on and off the water supply upon detection of the user's touch operation to the detection region 8.

(4) Lamp

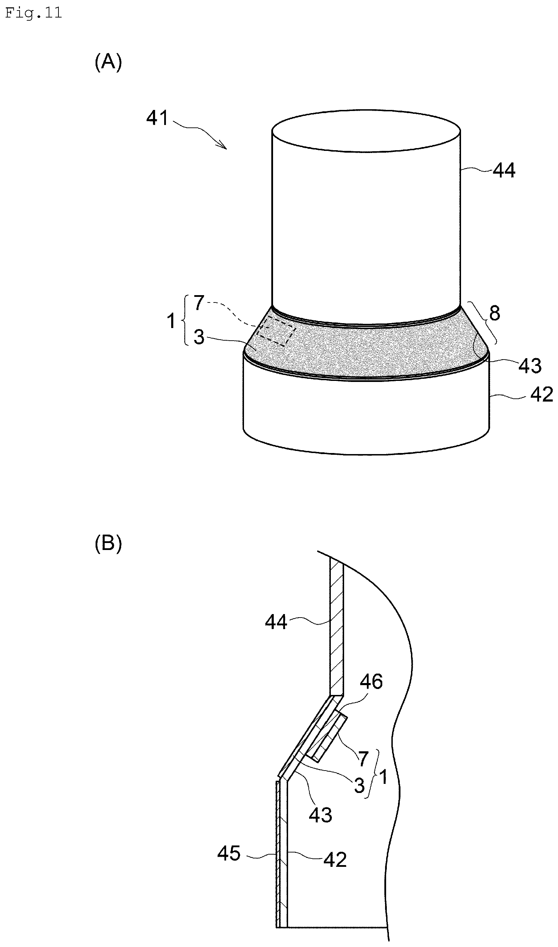

Fig. 11 is an example in which the electrostatic capacitance sensor 1 is used in a lamp 41. In the lamp 41 of the illustrated example, an inclined part 43, which is a part of a base 42-43, is a detection region 8 that detects the user's touch operation. The lamp 41 is configured to turn on and off a light source in response to the electrostatic capacitance sensor 1 detecting the action of the user's hand approaching the inclined part 43 as the touch operation. In the illustrated example, the sensor electrode 2 and detection device 4 of the electrostatic capacitance sensor 1 are in the form of a module 7 in which the sensor electrode 2 is incorporated into the detection device 4.

The base 42-43 is made of, for example, wood or synthetic resin, and the entire outer surface of the inclined part 43 is coated with, for example, metal plating as a conductor 3. The module 7 is attached to the inner surface of the inclined part 43 via a dielectric, such as an adhesive or double-sided tape 46, so as to face a part of the conductor 3. The module 7 is disposed at the upper end of the detection region 8. The entire outer surface of the lower portion 42 of the base 42-43 may also be coated with, for example, metal plating 45. However, a clearance is provided between the metal plating 45 on the outer surface of the lower portion 42 and the conductor 3 on the outer surface of the inclined part 43. The metal plating 45 is electrically disconnected from the conductor 3 and is preferably grounded. Further, a light source is disposed, for example, inside a glass cover 44 attached above the base 42-43. The light source is connected to a control device that controls the operation of the lamp 41, and the control device controls the supply of electricity to the light source using a known electrical/electronic circuit, switch, etc.

When the user approaches the hand to the inclined part 43 of the base 42-43, since the conductor 3 is provided over the entire area of the inclined part 43, which is the detection region 8, the capacitance of the conductor 3 increases, and the capacitance of the sensor electrode 2 also increases. This change in the capacitance of the sensor electrode 2 is detected by the detection device 4, whereby the electrostatic capacitance sensor 1 detects the user's touch operation to the detection region 8. This detection information is transmitted by wire or wirelessly as a control signal to the control device of the lamp 41, whereby the control device of the lamp 41 energizes the light source to turn on the lamp 41. On the other hand, when the user releases the hand from the inclined part 43 of the base 42-43, the capacitance of the conductor 3 decreases, and the capacitance of the sensor electrode 2 also decreases. Then, when the user approaches the hand again to the inclined part 43 of the base 42-43, the capacitance of the conductor 3 increases, and the capacitance of the sensor electrode 2 also increases. This change in the capacitance of the sensor electrode 2 is detected by the detection device 4, whereby the electrostatic capacitance sensor 1 detects the user's touch operation to the detection region **8.** As a result, this detection information is transmitted by wire or wirelessly as a control signal to the control device of the lamp 41, and the control device of the lamp 41 stops energizing the light source to turn off the lamp 41.

Various design variations are possible. For example, the inclined part 43 of the base 42-43 is divided into multiple regions along the circumferential direction to arrange multiple detection regions 8, and a conductor 3 and a module 7 are provided for each detection region 8, so that in the lamp 41, one detection region 8 turns on the lamp 41 upon detection of the user's touch operation, another detection region 8 turns off the lamp 41 upon detection of the user's touch operation, and another detection region 8 changes the color of the light of the lamp 41 upon detection of the user's touch operation.

In the example in which the electrostatic capacitance sensor 1 is used in the lamp 41, in place of the control device of the lamp 41, the control part 6 of the detection device 4 may be configured to energize the light source to turn on and off the lamp 41 upon detection of the user's touch operation to the detection region 8.

(5) Wireless Earphone

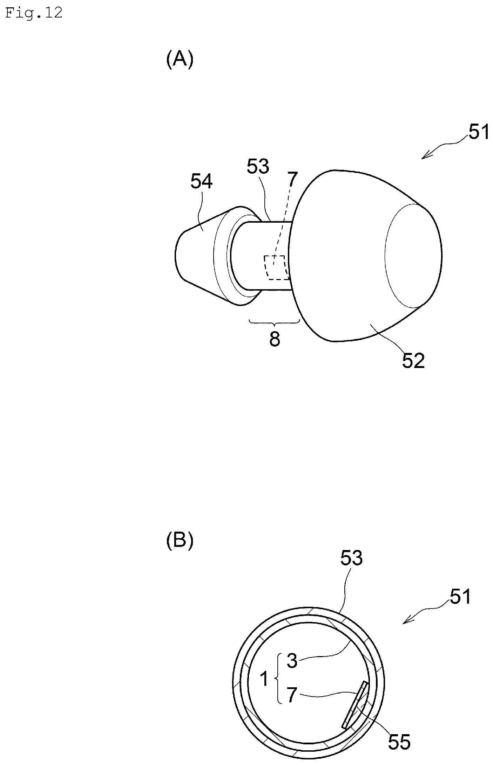

Fig. 12 shows an example in which the electrostatic capacitance sensor 1 is used in a wireless earphone 51. In the wireless earphone 51 of the illustrated example, a tip part 53 of a housing 52 is a detection region 8 that detects the user's touch operation. The wireless earphone 51 is configured to turn on and off the power in response to the electrostatic capacitance sensor 1 detecting the action of the user inserting the tip part 53 of the housing 52 into the ear canal as the touch operation. In the illustrated example, the sensor electrode 2 and detection device 4 of the electrostatic capacitance sensor 1 are in the form of a module 7 in which the sensor electrode 2 is incorporated into the detection device 4.

The housing 52 is made of, for example, synthetic resin, and the entire inner surface of the tip part 53 is coated with, for example, metal plating as a conductor 3. The module 7 is attached to a part of the conductor 3 via a dielectric, such as an adhesive or double-sided tape 55. The module 7 is disposed at the end opposite to the earpiece 54 in the tip part 53 of the housing 52, which is the detection region 8.

When the user inserts the tip part 53 of the wireless earphone 51 into the ear canal, since the conductor 3 is provided over the entire area of the tip part 53, which is the detection region 8, the capacitance of the conductor 3 increases, and the capacitance of the sensor electrode 2 also increases. This change in the capacitance of the sensor electrode 2 is detected by the detection device 4, whereby the electrostatic capacitance sensor 1 detects the user's touch operation to the detection region 8. This detection information is transmitted by wire or wirelessly as a control signal to a control device that controls the operation of the wireless earphone 51, whereby the control device of the wireless earphone 51 turns on the power of the wireless earphone 51 via a known electrical/electronic circuit, switch, etc. On the other hand, when the user removes the wireless earphone 51 from the ear, the capacitance of the conductor 3 decreases, and the capacitance of the sensor electrode 2 also decreases. This change in the capacitance of the sensor electrode 2 is detected by the detection device 4, whereby the electrostatic capacitance sensor 1 detects the release of the user's touch operation to the detection region 8. This detection information is transmitted by wire or wirelessly as a control signal to the control device of the wireless earphone 51, whereby the control device of the wireless earphone 51 turns off the power of the wireless earphone 51.

In the example in which the electrostatic capacitance sensor 1 is used in the wireless earphone 51, in place of the control device of the wireless earphone 51, the control part 6 of the detection device 4 may be configured to turn on and off the power of the wireless earphone 51 upon detection of the user's touch operation to the detection region 8.

Further, in the example in which the electrostatic capacitance sensor 1 is used in the wireless earphone 51, it is possible to redesign the wireless earphone 51 to a hearing aid.

(6) Touch Switch

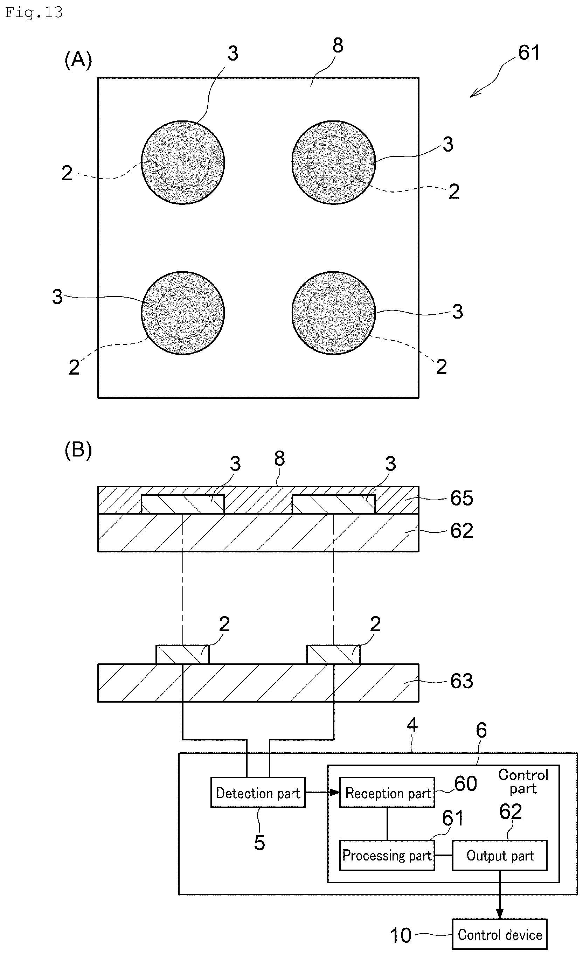

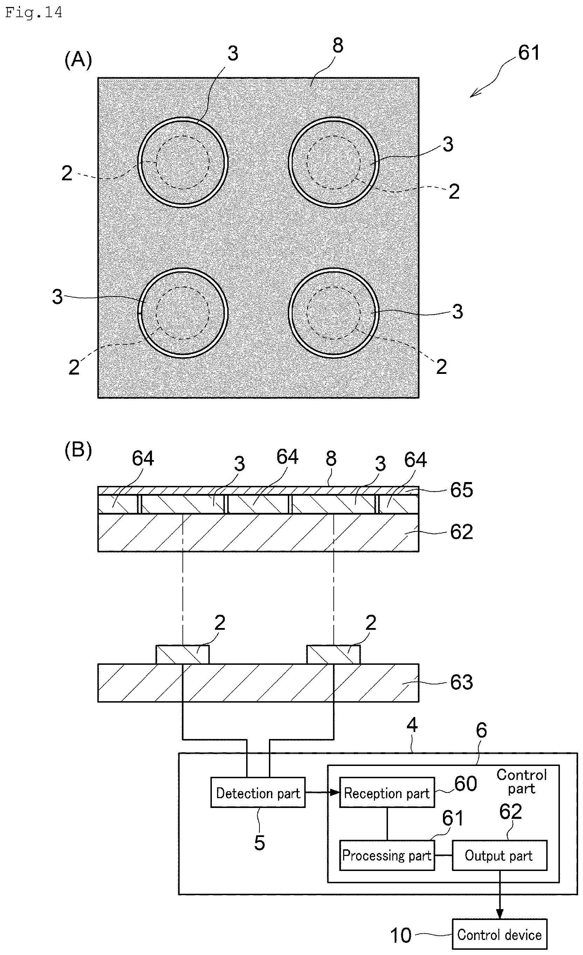

Figs. 13 and 14 show an example in which the electrostatic capacitance sensor 1 is used in a touch switch 61 for use in, for example, elevators, automatic doors, and touch panels, which allows the selection of various functions to be executed by equipment by simply touching it lightly, rather than by pressing a button.

The touch switch 61 of the illustrated example has one or more sensor electrodes 2 on the upper surface of a printed circuit board 63, and a cover plate 62 made of, for example, synthetic resin or wood, spaced above the printed circuit board 2. On the upper surface of the cover plate 62, one or more conductors 3 are provided corresponding to the respective sensor electrodes 2. The conductor 3 is made of, for example, a metal film. In Fig. 14, for example, metal films 64 are formed on the upper surface of the cover plate 62 in areas other than the conductors 3, and the surface of the touch switch 61 has a metallic finish. In Fig. 14, a clearance is provided between the metal film 64 and the conductor 3, the metal film 64 and the conductor 3 are electrically disconnected from each other, and the metal film 64 is grounded. On the upper surface of the cover plate 62, for example, a non-conductive surface layer 65, such as a resin film or a resin panel, is provided to cover the conductors 3 and the metal films 64. The surface of the touch switch 61, i.e., the upper surface of the surface layer 65 in this example, is a detection region 8 that detects the user's touch operation, and the positions of the respective conductors 3 correspond to the positions for the various button operations of the touch switch 61.

The electrostatic capacitance sensor 1 detects, as the user's touch operation, the user's finger contacting or approaching any button operation position in the detection region 8. When the user contacts or approaches the finger to any button operation position in the detection region 8, the capacitance of the conductor 3 in the button operation position increases, and the capacitance of the sensor electrode 2 corresponding to the conductor 3 increases. The detection part 5 of the detection device 4 detects the change in the capacitance of each sensor electrode 2 to thereby detect the position where the touch operation has been performed in the detection region 8, and outputs a detection signal to the control part 6 indicating in which button operation position in the detection region 8 the touch operation has been performed. Based on the detection signal, the control part 6 determines whether the touch operation has been performed in any button operation position in the detection region 8, and outputs a control signal to the control device 10 installed in the equipment to cause the equipment to execute the function set in the button operation position where the touch operation has been performed.

Description of Modifications

The electrostatic capacitance sensor of the present disclosure is described above; however, the above embodiment is merely illustrative and not restrictive. Therefore, the electrostatic capacitance sensor of the present disclosure is not limited to the above embodiment, and various modifications are possible without departing from the spirit of the present disclosure.

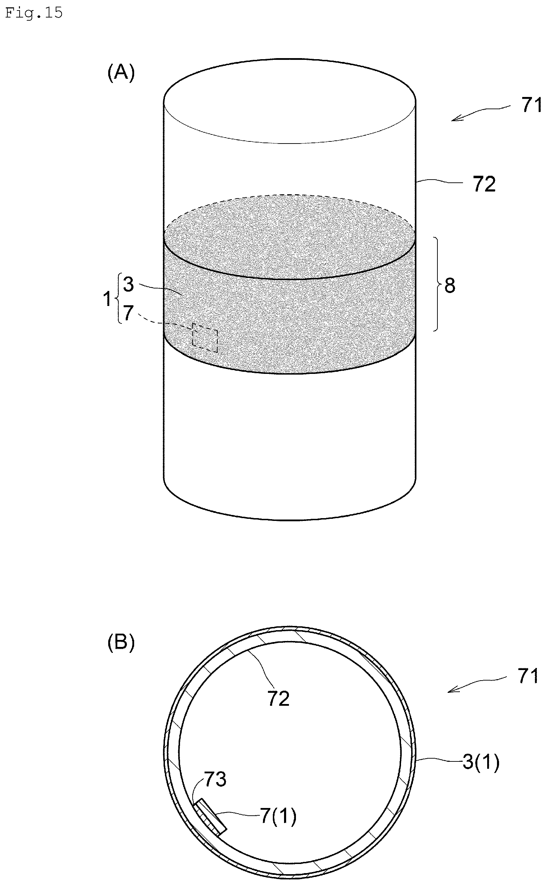

For example, in the above embodiment, the action of a part of the user's body, such as a finger, as a detectable object contacting or approaching the detection region 8 (touch operation) is detected. However, the detectable object may not be a part of the human body, and may be, for example, a liquid such as water. For example, as shown in Fig. 15, the electrostatic capacitance sensor 1 of the present disclosure can be used as a water level sensor 71.

In the water level sensor 71 shown in Fig. 15, a part in the height direction of a bottomed cylindrical tank 72 for storing liquid, such as water, is a detection region 8 that detects the water level. The water level sensor 71 is configured to detect whether the liquid level has reached the detection region 8 in response to the electrostatic capacitance sensor 1 detecting the action of the liquid approaching the detection region 8 as the amount of liquid increases or decreases. In the illustrated example, the sensor electrode 2 and detection device 4 of the electrostatic capacitance sensor 1 are in the form of a module 7 in which the sensor electrode 2 is incorporated into the detection device 4.

The tank 72 is made of, for example, wood or synthetic resin, and the entire outer surface of the detection region 8 in the tank 72 is coated with, for example, metal plating as a conductor 3. The module 7 is attached to the inner surface of the detection region 8 in the tank 72 so as to face a part of the conductor 3 via a dielectric, such as an adhesive or double-sided tape 73. The module 7 is disposed at the lower end of the detection region 8. In the height direction of the tank 72, the entire outer surface of the portion other than the detection region 8 can be coated with metal plating, for example; however, a clearance is provided between the metal plating and the conductor 3 on the outer surface of the detection region 8, and the metal plating is electrically disconnected from the conductor 3 and is preferably grounded.

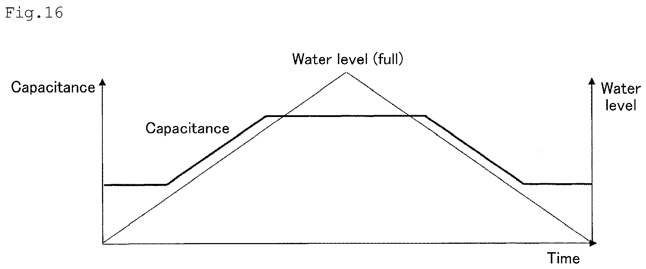

When liquid is supplied into the tank 72 from an inlet (not shown), the liquid level rises and reaches the lower end of the detection region 8. At this time, since the conductor 3 is provided over the entire detection region 8, the capacitance of the conductor 3 increases, and the capacitance of the sensor electrode 2 also increases, as shown in Fig. 16. This change in the capacitance of the sensor electrode 2 is detected by the detection device 4, and this detection information is transmitted by wire or wirelessly as a control signal to the control device of the water level sensor 71, whereby the control device of the water level sensor 71 detects that the liquid is stored up to a predetermined height in the tank 72. When liquid is further supplied into the tank 72 and the liquid level is positioned above the upper end of detection region 8, the capacitance of the conductor 3 is maintained constant, and the capacitance of the sensor electrode 2 is maintained constant. This detection information is transmitted by wire or wirelessly as a control signal to the control device of the water level sensor 71, whereby the control device of the water level sensor 71 detects that the liquid is stored above the predetermined height in the tank 72. Thereafter, the liquid is discharged from the tank 72 through an outlet (not shown), and when the liquid level drops to the upper end of the detection region 8, the capacitance of the conductor 3 decreases, and the capacitance of the sensor electrode 2 decreases. This change in the capacitance of the sensor electrode 2 is detected by the detection device 4, and this detection information is transmitted by wire or wirelessly as a control signal to the control device of the water level sensor 71, whereby the control device of the water level sensor 71 detects that the liquid is stored again up to the predetermined height in the tank 72. When the liquid is further discharged outside the tank 72 and the liquid level drops below the lower end of the detection region 8, the capacitance of the conductor 3 is maintained constant, and the capacitance of the sensor electrode 2 is maintained constant. This detection information is transmitted by wire or wirelessly as a control signal to the control device of the water level sensor 71, whereby the control device of the water level sensor 71 detects that the liquid is not stored up to the predetermined height in the tank 72.

In the example in which the electrostatic capacitance sensor 1 is used as the water level sensor 71, in place of the control device of the water level sensor 71, the control part 6 of the detection device 4 may be configured to detect whether the liquid level is at a predetermined height in the tank 72.

Reference Signs List

1. Electrostatic capacitance sensor
2. Sensor electrode
3. Conductor
4. Detection device
5. Detection part
6. Control part
7. Module
8. Detection region of equipment
9. Detectable object
10. Control device of equipment

**Claims**

1. An electrostatic capacitance sensor comprising a sensor electrode, and a detection device for detecting a contact or approach action of a detectable object with respect to a detection region based on a change in the capacitance of the sensor electrode,

   the electrostatic capacitance sensor comprising a conductor provided in the detection region,
   the conductor being disposed opposite to the sensor electrode with a gap therebetween or with a dielectric interposed therebetween,
   the area of the conductor, as viewed from a direction in which the sensor electrode and the conductor face each other, being larger than the area of the sensor electrode, and a part of the conductor facing the sensor electrode,
   the detection device comprising a detection part for detecting a change in the combined capacitance of the capacitance of the conductor and the capacitance of the sensor electrode as a change in the capacitance of the sensor electrode, and a control part, and
   the detection part comprising a CV amplifier for converting the change in capacitance into a change in voltage, and the control part being configured to detect the contact or approach action of the detectable object with respect to the detection region based on a detection signal corresponding to the change in voltage output from the detection part.

2. The electrostatic capacitance sensor according to claim 1, wherein the conductor is provided over the entire detection region.

3. The electrostatic capacitance sensor according to claim 1, wherein the conductor is composed of any of conductive ink, a conductive resin, a metal film, a metal sheet, a metal plate, a metal mesh, a conductive woven fabric, a conductive knitted fabric, and a conductive non-woven fabric.

4. The electrostatic capacitance sensor according to any one of claims 1 to 3, wherein the detection region is a toilet seat,

   the conductor is provided on a back side of the toilet seat, and
   the sensor electrode is fixed to a part of the conductor via the dielectric.

Fig.1

$h_0$

2

6   4

Control
part   60   Reception part   ◄   Detection part

62

61

Output part   Processing part

5

1

Control device

10

Fig.2

$h_1$

$h$

$3$

$8$

$h_0$

**Control part**

60   Reception part

62   61

Output part   Processing part

6   4   2

9

Detection part

1

5

Control device

10

Fig.3

(A)

$$C_0$$

$$C_1$$

$$\frac{C_0 \times C_1}{C_0 + C_1} \text{ Output}$$

4

5 Detection part

6 Control part

ret

(B)

$$C_0$$

$$\triangle C$$

$$C_1$$

$$\frac{(C_0 + \triangle C) \times C_1}{C_0 + \triangle C + C_1} \text{ Output}$$

4

5 Detection part

6 Control part

ret

Fig.4

(A)

$C_0$

Detection part → Control part

$C_0$ Output

ret

(B)

$C_0$

$\triangle C$

Detection part → Control part

$C_0 + \triangle C$ Output

ret

Fig.5

Fig.6

(A)

(B)

Fig.7

Fig.8

Fig.9

Fig.10

(A)

(B)

(C)

Fig.11

(A)

41

44

7
1
3

8

43

42

(B)

44

46

7
1
3

43

45

42

Fig.12

(A)

(B)

Fig.13

(A)

(B)

Fig.14

(A)

(B)

Fig.15

(A)

(B)

Fig.16

Fig.17

(A)

$C_1$
10pF

$C_0$
40pF

5V

2kΩ

(B)

Current measurement simulation when no detectable object is detected

Peak:1.95mA

2.2mA
2.0mA
1.8mA
1.6mA
1.4mA
1.2mA
1.0mA
0.8mA
0.6mA
0.4mA
0.2mA
0.0mA

0μs          3μs          6μs          9μs          12μs

Fig.18

(A)

(B)

Current measurement simulation when a detectable object is detected

Peak:2.05mA

Fig.19

(A)

(B)

Current measurement simulation when no detectable object is detected

Peak: 1.70mA

Fig.20

(A)

(B)

Current measurement simulation when a detectable object is detected

Fig.21

(A)

(B)

Voltage measurement simulation when no detectable object is detected

V/2

Peak: 2.5V

Fig.22

(A)

(B)

Voltage measurement simulation when a detectable object is detected

Peak: 2.6V

Fig.23

(A)

(B)

Voltage measurement simulation when no detectable object is detected

Peak: 3.5V

Fig.24

(A)

(B)

Voltage measurement simulation when no detectable object is detected

Peak: 2.5v

Fig.25

(A)

(B)

## INTERNATIONAL SEARCH REPORT

| International application No. |
| --- |
| **PCT/JP2023/027214** |

**A.    CLASSIFICATION OF SUBJECT MATTER**

*G01V 3/08*(2006.01)i; *H01H 36/00*(2006.01)i
FI:    G01V3/08 D; H01H36/00 J

According to International Patent Classification (IPC) or to both national classification and IPC

**B.    FIELDS SEARCHED**

Minimum documentation searched (classification system followed by classification symbols)

G01V1/00-99/00; H01H36/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| --- | --- | --- |
| A | JP 2021-99297 A (TOYO LABEL KK) 01 July 2021 (2021-07-01) entire text, all drawings | 1-4 |
| A | JP 2007-175163 A (TOTO LTD) 12 July 2007 (2007-07-12) entire text, all drawings | 1-4 |
| A | JP 2019-526318 A (HERMAN MILLER, INC) 19 September 2019 (2019-09-19) entire text, all drawings | 1-4 |
| A | JP 2021-100228 A (TOYO LABEL KK) 01 July 2021 (2021-07-01) entire text, all drawings | 1-4 |
| A | JP 2014-228335 A (TOYOTA MOTOR CORP) 08 December 2014 (2014-12-08) entire text, all drawings | 1-4 |
| A | US 2011/0169506 A1 (IDENT TECHNOLOGY AG) 14 July 2011 (2011-07-14) entire text, all drawings | 1-4 |

☐ Further documents are listed in the continuation of Box C.          ☑ See patent family annex.

| | |
| --- | --- |
| *    Special categories of cited documents: | "T"    later document published after the international filing date or priority date and not in conflict with the application but cited to understand the principle or theory underlying the invention |
| "A"    document defining the general state of the art which is not considered to be of particular relevance | |
| "E"    earlier application or patent but published on or after the international filing date | "X"    document of particular relevance; the claimed invention cannot be considered novel or cannot be considered to involve an inventive step when the document is taken alone |
| "L"    document which may throw doubts on priority claim(s) or which is cited to establish the publication date of another citation or other special reason (as specified) | "Y"    document of particular relevance; the claimed invention cannot be considered to involve an inventive step when the document is combined with one or more other such documents, such combination being obvious to a person skilled in the art |
| "O"    document referring to an oral disclosure, use, exhibition or other means | |
| "P"    document published prior to the international filing date but later than the priority date claimed | "&"    document member of the same patent family |

| Date of the actual completion of the international search | Date of mailing of the international search report |
| --- | --- |
| **14 September 2023** | **26 September 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT
### Information on patent family members

International application No.

**PCT/JP2023/027214**

| Patent document cited in search report | | | Publication date (day/month/year) | Patent family member(s) | | | Publication date (day/month/year) |
|---|---|---|---|---|---|---|---|
| JP | 2021-99297 | A | 01 July 2021 | (Family: none) | | | |
| JP | 2007-175163 | A | 12 July 2007 | (Family: none) | | | |
| JP | 2019-526318 | A | 19 September 2019 | US | 2018/0043794 | A1 | |
| | | | | WO | 2018/031989 | A1 | |
| | | | | CN | 109561768 | A | |
| JP | 2021-100228 | A | 01 July 2021 | (Family: none) | | | |
| JP | 2014-228335 | A | 08 December 2014 | US | 2016/0087629 | A1 | |
| | | | | WO | 2014/188257 | A1 | |
| | | | | CN | 105247790 | A | |
| US | 2011/0169506 | A1 | 14 July 2011 | WO | 2010/037758 | A1 | |
| | | | | DE | 102008050181 | A1 | |
| | | | | DE | 102008050186 | A1 | |
| | | | | DE | 202008013083 | U1 | |
| | | | | DE | 102008052324 | A1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015210811 A
- JP 2021099297 A
- JP 2021 A
- JP 99297 A